# FASCICULE DE BREVET EUROPEEN

(11) **EP 0 474 184 B1**
(45) Date de publication et mention de la délivrance du brevet: **02.11.1994**
(21) Numéro de dépôt: 91114834.4
(22) Date de dépôt: 03.09.1991
(51) Int. Cl.: H01R 9/05

(54) **Connecteur pour câble de type paire blindée à drain de masse**
Verbinder für geschirmtes Zweileiterkabel mit Erdungsdrain
Connector for twin wire shielded cable with earth drain

(30) Priorité: 07.09.1990 FR 9011116
(43) Date de publication de la demande: 11.03.1992
(73) Titulaire: CEGELEC, 92309 Levallois-Perret (FR)
(72) Inventeur: Gelin, Claude, F-94000 Creteil (FR); Bordino, Christian, F-91680 Bruyères le Chatel (FR)
(74) Mandataire: Weinmiller, Jürgen

(56) Documents cités:
- EP-A- 0 400 521
- DE-A- 3 418 582

## Description

L'invention concerne un connecteur destiné à assurer le raccordement d'un appareillage émetteur et/ou récepteur de données à un câble de transmission du type à paire blindée et à drain de masse.

Les avantages des liaisons par paire blindée sont connus et exploités depuis longtemps dans le domaine des télécommunications. Ces liaisons dont l'installation s'effectue selon des techniques éprouvées relativement simples et peu coûteuses, permettent en effet la transmission de signaux tant analogiques que numériques, notamment en point à point, dans de bonnes conditions et avec de bonnes performances.

Ceci a donc conduit à la préconisation de leur emploi dans les réseaux locaux, pour interconnecter des appareillages dotés à cet effet d'équipements émetteurs et/ou récepteurs de données identiquement reliés à une ou plusieurs liaisons partagées.

Chacun des équipements répartis au long d'une liaison, vient alors se raccorder par l'intermédiaire d'un connecteur en un emplacement particulier qui lui est attribué sur le câble qui constitue cette liaison et, dans une forme classique de réalisation, les équipements sont connectés en série l'un à la suite de l'autre.

Pour des raisons, notamment de continuité électrique au niveau des fils conducteurs utilisés pour la transmission des données et du blindage les protégeant contre les parasites électromagnétiques, on s'efforce de limiter au minimum les dégradations à effectuer sur un câble pour y raccorder les connecteurs servant au branchement des équipements émetteurs/récepteurs de données des appareillages desservis.

Ceci a conduit notamment à la création de câbles dont l'ensemble des fils de transmission des données est classiquement entouré d'une gaine, formant un écran de blindage électromagnétique, à laquelle est associée un drain conducteur, longitudinal, de continuité d'écran qui, galvaniquement connecté à cette gaine en est cependant séparable, lorsque celle-ci doit être localement éliminée pour permettre un accès d'un connecteur aux fils de transmission, le drain étant susceptible d'être maintenu intact au niveau du connecteur et par conséquent d'assurer la continuité électrique de l'écran au long du câble, malgré l'élimination réalisée.

Ceci a aussi conduit au développement de connecteurs dotés de blocs de raccordement spécifiques, tel que celui décrit dans la demande de brevet français n° 2647970 (équivalente à la demande européenne EP-A-0 400 521 publiée le 05/12/90) de la demanderesse, succinctement présenté plus loin, permettant le raccordement d'un équipement émetteur et/ou récepteur d'un appareillage par l'intermédiaire d'un câble de dérivation blindé, comportant deux paires de fils de transmission, à un câble blindé tel qu'évoqué plus haut qui comporte une paire de fils de transmission et un drain de continuité d'écran et qui est destiné à desservir plusieurs équipements émetteurs/récepteurs connectés à lui en série.

Un des objectifs de la présente invention est d'améliorer les performances en transmission des liaisons équipées de ce type de connecteur, par action sur les connecteurs eux-mêmes et de notamment permettre de vérifier le bon état de fonctionnement des liaisons et en conséquence du système qui les comporte.

La présente invention propose donc un connecteur du type évoqué ci-dessus, qui est destiné à permettre le raccordement d'un équipement émetteur et/ou récepteur d'un appareillage par l'intermédiaire d'un câble de dérivation blindé comportant deux paires de fils individuellement isolés de transmission, à un câble blindé, tel qu'évoqué plus haut, qui comporte une paire de fils individuellement isolés de transmission et un drain de continuité d'écran à l'intérieur d'une gaine constituant ledit écran de blindage électromagnétique et qui comporte, à cet effet, un bloc de raccordement composé d'un élément support dans lequel est logé un dispositif de coupure placé entre quatre pièces de connexion par pincement et à cisaillement d'isolant, permettant chacune une connexion individuelle de deux fils isolés et destinées à recevoir chacune un des quatre fils de transmission du câble de dérivation et un des deux fils de transmission du câble à drain, le dispositif de coupure étant déplaçable dans un logement de l'élément support entre une première position permettant le passage de deux fils en traversée entre chacun deux pièces de connexion, situées de part et d'autre d'un compartiment du logement et différentes pour les deux fils en traversée, et une seconde position dans laquelle le dispositif de coupure s'interpose entre les pièces de connexion situées de part et d'autre d'un compartiment du logement, après avoir éventuellement sectionné les fils préalablement en traversée.

Selon une caractéristique de l'invention, le connecteur qui est logé dans un boîtier en matériau isolant, comporte une cage de Faraday interne où pénètrent les conducteurs des câbles, dans laquelle sont notamment logés l'élément support et les pièces de connexion et à laquelle sont reliées les gaines desdits câbles de manière à former avec ces gaines de câble un contenant étanche aux parasites électromagnétiques et en ce que ladite cage est reliée à deux bornes de masse accessibles de l'extérieur du boîtier, directement pour l'une et via un condensateur pour l'autre.

L'invention, ses caractéristiques et ses avantages sont précisés dans la description qui suit, en liaison avec les figures répertoriées ci-dessous.

Les figures 1 et 2 présentent respectivement un schéma en vue de dessus et en vue de côté du bloc de raccordement connu tel que défini dans la demande de brevet EP-A-0 400 521, évoquée ci-dessus de la demanderesse.

Les figures 3 et 4 présentent respectivement une pièce de connexion et un dispositif de coupure du bloc de raccordement connu, selon les figures 1 et 2.

Les figures 5 et 6 présentent un schéma de deux variantes de connecteur selon la présente invention.

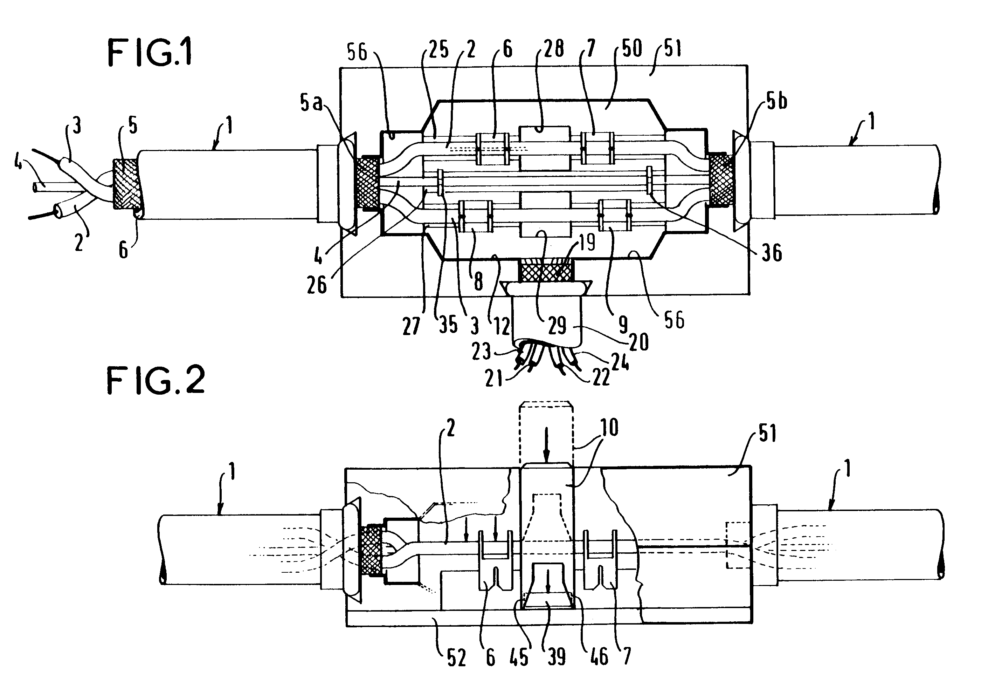

Le bloc de raccordement connu présenté en figure 1 est destiné à assurer la connexion d'un appareillage, non représenté, sur un câble 1, blindé électromagnétiquement, qui comporte une paire de fils conducteurs de transmission 2 et 3, un drain 4 de continuité d'écran, une gaine métallique 5 formant écran électromagnétique pour les fils de transmission et un gainage isolant 6 couvrant la gaine métallique 5, le drain 4, électriquement conducteur est en contact avec la gaine 5 sur toute la longueur du câble qui les comporte.

Le montage d'un connecteur sur un câble 1 qui vient le traverser, implique l'élimination partielle du gainage isolant 6 et de la gaine métallique 5 de ce câble à l'emplacement prévu pour ce connecteur pour permettre d'accéder aux fils 2 et 3 ainsi qu'accessoirement au drain 4, au moyen de pièces de connexion qui sont par exemple assujetties à un élément support prévu dans le connecteur.

Dans la réalisation considérée, il est prévu de connecter chacun des fils 2 et 3, respectivement, l'un à deux pièces de connexion 6 et 7 disposées de part et d'autre d'un compartiment 28 interrompant une goulotte 25 prévue pour le passage en traversée de ce fil, tel 2, entre ces deux pièces 6 et 7, dans un élément support 50, l'autre à deux pièces de connexion 8 et 9 disposées de part et d'autre d'un compartiment 29 interrompant une goulotte 27 qui est parallèle à la goulotte 25 et qui est prévue pour permettre le passage en traversée de cet autre fil, tel 3, entre les pièces 8 et 9.

Une goulotte 26 est également prévue dans l'élément support 50 pour le passage en traversée du drain 4, elle est située entre les goulottes 25 et 27 auxquelles elle est parallèle. Deux pièces 35, 36 positionnées dans cette goulotte permettent d'immobiliser le drain 4 que l'on y loge, d'une manière analogue à celle par laquelle les fils 2 ou 3 sont immobilisés dans les pièces de connexion; dans la réalisation envisagée, elles permettent aussi un raccordement du drain au blindage électromagnétique du connecteur.

Ces pièces de connexion 6 à 9 sont du type à fourche et assurent la connexion et le coincement d'un fil électriquement isolé dans une fente de fourche où la couche isolante couvrant ce fil est cisaillée, lors de la phase d'insertion du fil.

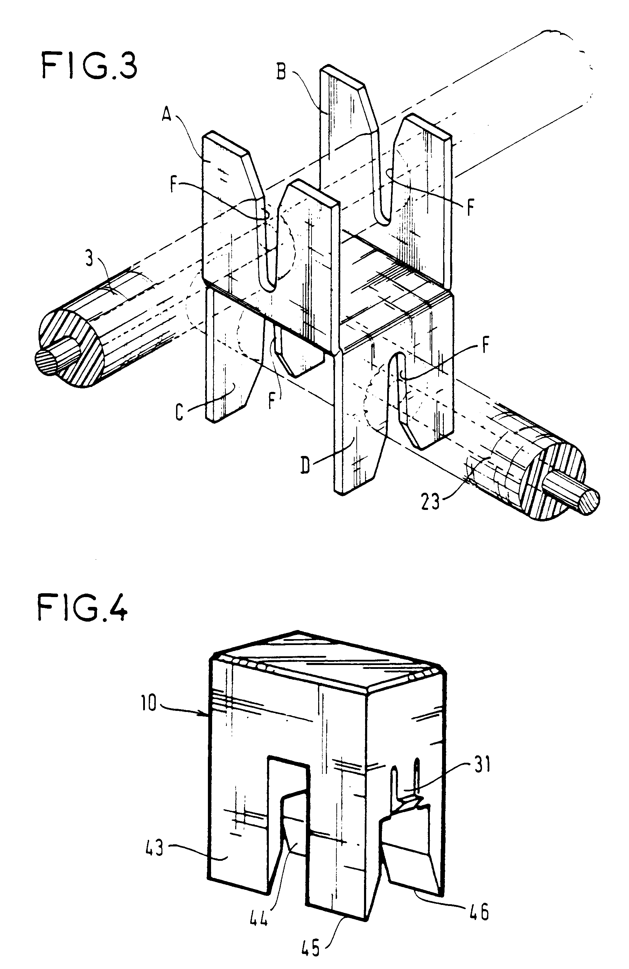

Chaque pièce de connexion 6 à 9, réalisée en un matériau bon conducteur, comporte deux paires perpendiculaires de fourches parallèles A à D, les fentes F parallèles des deux fourches A, B d'une paire s'évasant dans une direction opposée de celles des fourches C, D de l'autre paire, ainsi qu'on le voit sur la figure 3, de manière à permettre indépendamment une double connexion de deux fils différents, tels 3 et 23, au moyen d'une seule pièce. Dans une première forme de réalisation - figure 1 -, l'appareillage à raccorder, vient se relier au bloc de raccordement par l'intermédiaire d'un câble de dérivation 20, électromagnétiquement blindé, destiné à permettre un montage en série de cet appareillage, via une dérivation. Le câble de dérivation 20 comporte classiquement une gaine métallique 19 formant écran et recouvrant quatre fils de transmission 21, 22, 23, 24 individuellement recouverts d'une couche isolante.

Les pièces de connexion 6 à 9 reçoivent chacune l'un des deux conducteurs 2 ou 3 dans les fentes parallèles F d'une paire de fourches, par exemple A, B et l'un des quatre conducteurs 21 à 24 dans les fentes F de l'autre paire de fourches C, D.

La mise en série de l'appareillage sur le câble 1 par l'intermédiaire du câble de dérivation 20 s'effectue par coupure des fils 2 et 3 entre les pièces de connexion qui les maintiennent, dans la zone où ces fils, logés dans les goulottes 25, 27, traversent chacun l'un des compartiments 28, 29 situés sur leur passage.

Cette coupure des fils 2 et 3 est effectuée au moyen d'un dispositif 10 déplaçable dans l'élément support 50 entre deux positions. Dans une première position avant connexion, qui est ici prévue en saillie, du dispositif de coupure 10 et qui est montrée en pointillé sur la figure 2, il est possible d'assurer le passage des fils 2 et 3 en traversée entre les bornes de connexion 6, 7 pour l'un et 8, 9 pour l'autre, au travers des compartiments 28 pour l'un et 29 pour l'autre.

Le déplacement ici par enfoncement du dispositif de coupure 10 jusqu'à une seconde position assure la coupure des fils 2 et 3 en raison de la forme en couteau donnée aux parties concernées du dispositif de coupure 10 - voir figures 2 et 4 -.

A cet effet ce dispositif de coupure 10, ici réalisé en matériau isolant moulé, comporte une partie commune qui est en saillie hors de l'élément support 50, avant connexion, et qui sert de poussoir lors de l'enfoncement. Cette partie commune se prolonge par deux unités de coupe dotées chacune de deux lames de couteau, telles 43 et 44 pour l'une destinée à pénétrer dans l'un des compartiments, soit ici 28, et telles 45 et 46 pour l'autre destinée à pénétrer dans l'autre compartiment 29.

Les deux lames, telles 45 et 46, d'une unité de coupe viennent coulisser contre les parois du compartiment, tel 29, qui sont en regard et qui sont perpendiculaires à la goulotte, telle 27, qu'interrompt ce compartiment.

L'enfoncement du dispositif de coupure 10, préalablement positionné au dessus des fils courant dans les goulottes 25, 27 entraîne le sectionnement d'un tronçon de ces fils par les deux lames qui viennent s'y appuyer au niveau des bordures communes aux goulottes et parois des compartiments qui leur sont perpendiculaires.

Le dispositif de coupure 10 se verrouille dans les compartiments 28, 29 en position basse après sectionnement des fils, il est maintenu par les harpons terminaux de pattes élastiques qu'il comporte, tel 31 figure 4, ces harpons venant s'encliqueter dans des alvéoles correspondantes non figurées des parois internes des compartiments.

Les deux tronçons de fil coupés par les couteaux du dispositif de coupure 10 sont maintenus en position basse chacun dans un vide d'un compartiment sous le dispositif de coupure ce qui permet d'empêcher tout court-circuit par déplacement intempestif de ces tronçons dans le connecteur.

L'appareillage, non représenté, qui est relié par un des fils 21 à 24 à chacune des deux parties des fils 2 et 3 qui ont été déconnectées par le déplacement du dispositif de coupure 10, est simultanément connecté en série sur la liaison de transmission constituée par ces fils 2, 3.

La saillie ou non du dispositif de coupure 10 hors du connecteur comme montré en pointillé sur la figure 2 permet à l'utilisateur de détecter visuellement si la connexion en dérivation est à réaliser ou si elle a déjà été réalisée.

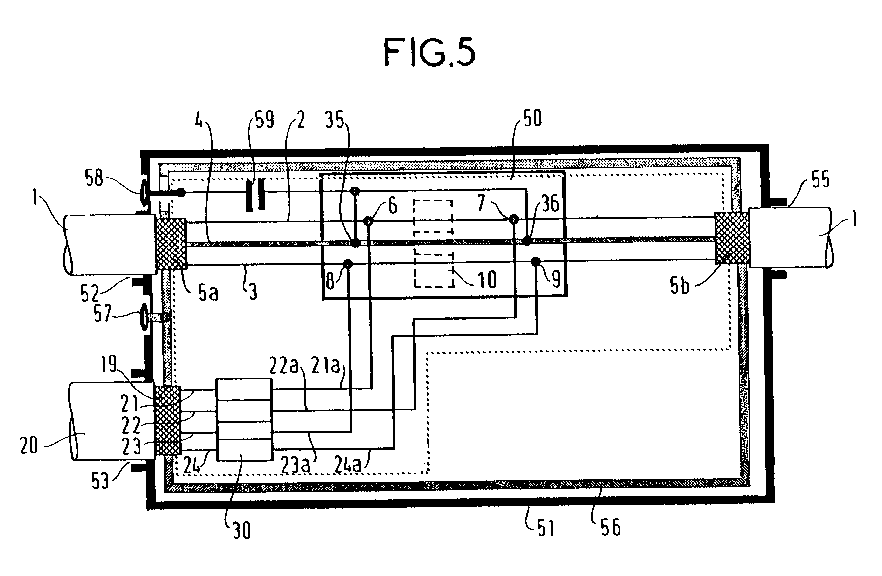

Dans l'exemple de réalisation présenté en figure 5, l'élément support 50 équipé des pièces 6 à 9 et 35, 36 vient se positionner de manière éventuellement amovible à l'intérieur d'un boîtier 51 qui est par exemple constitué de deux demi-coques accolées, ces dernières étant munies d'orifices permettant notamment le passage des câbles 1 et 20. Ces orifices présentés au nombre de trois et référencés 52, 53, 55 sont dotés de dispositifs classiques non figurés, par exemple de type presse-étoupe, permettant d'immobiliser les câbles par rapport au boîtier 51, tout en assurant une bonne étanchéité.

Dans l'exemple présenté, une traversée du câble 1 au travers du boîtier 51 du connecteur est réalisée par passage de ce câble par deux orifices 52 et 55, situés en regard sur deux des facettes latérales opposées du boîtier, un orifice 53 disposés latéralement par rapport à l'orifice 52, sur la même facette, permettant l'entrée du câble de dérivation 20.

Dans la réalisation envisagée, les conducteurs 21 à 24 du câble de dérivation 20 aboutissent sur un bornier 30 par l'intermédiaire duquel ils sont individuellement reliés aux pièces de connexion 6 à 9, via des liaisons 21a à 23a préférablement préétablies, par exemple lors de l'assemblage du connecteur en usine à l'occasion de sa fabrication.

Pour éviter toute perturbation des signaux transmis par les câbles 1 et 20 par des parasites, au niveau du boîtier 51 du connecteur où les gaines métalliques 5 et 19 de ces câbles sont interrompues, ce boîtier est lui-même électromagnétiquement blindé et assure une continuité d'écran avec les gaines métalliques des câbles. Dans la réalisation proposée où il est prévu un boîtier en matériau isolant moulé, celui-ci comporte une cage de Faraday 56, interne, à laquelle viennent se connecter la gaine 19 du câble de dérivation et les deux extrémités dissociées 5a, 5b de la gaine 5 du câble 1, alors que les conducteurs des câbles pénètrent dans la cage par des orifices appropriés, selon des techniques bien connues de l'homme de métier.

La cage de Faraday 56 est par exemple réalisée à l'aide de pièces en aluminium qui viennent se placer contre la paroi interne du boîtier 51 de manière à former un contenant étanche aux parasites électromagnétiques dans lequel pénètrent les conducteurs des câbles 1 et 20 et où sont enfermés l'élément support, les pièces qu'il porte et des éléments auxiliaires de connexion qui seront précisés plus loin.

Ce contenant que forme la cage de Faraday 56 peut également être obtenu par métallisation épaisse de la paroi interne du boîtier 51.

Quelle que soit la solution choisie, la cage de Faraday 56 est munie d'une première borne de raccordement 57, accessible depuis l'extérieur du boîtier 51, cette borne permet de relier la cage de Faraday directement à une masse, ainsi que par conséquent les extrémités 5a, 5b de la gaine métallique 5, le drain 4 et la gaine métallique 19, lorsque les câbles 1 et 20 sont en place.

Une seconde borne de raccordement 58 est accessible depuis l'extérieur du boîtier 51, cette borne est aussi reliée à la cage de Faraday 56 par l'intermédiaire d'un condensateur 59, elle permet de relier la cage de Faraday, les extrémités 5a, 5b de la gaine métallique 5, le drain 4 et la gaine métallique 19, à une masse pour permettre l'élimination des signaux parasites qui ne sont pas constitués par un potentiel continu et en particulier les signaux parasites de type haute fréquence.

Dans la réalisation envisagée, le condensateur 59 a une capacité de 4,7 nF, il est placé dans la cage de Faraday 56 pour être protégé et il est directement connecté d'une part aux pièces conductrices 35, 36 assurant le positionnement du drain 4 sur l'élément support 50, d'autre part à la borne 58.

Lors de l'utilisation d'une pluralité d'appareillages en série sur un même câble a drain 1, chacun des connecteurs desservant respectivement ces appareillages est relié par sa borne 58 à une masse, à l'exception du connecteur placé centralement par rapport aux autres dont seul la borne 57 est reliée à la masse, ceci évitant notamment d'avoir à isoler ces connecteurs par rapport au câble 1.

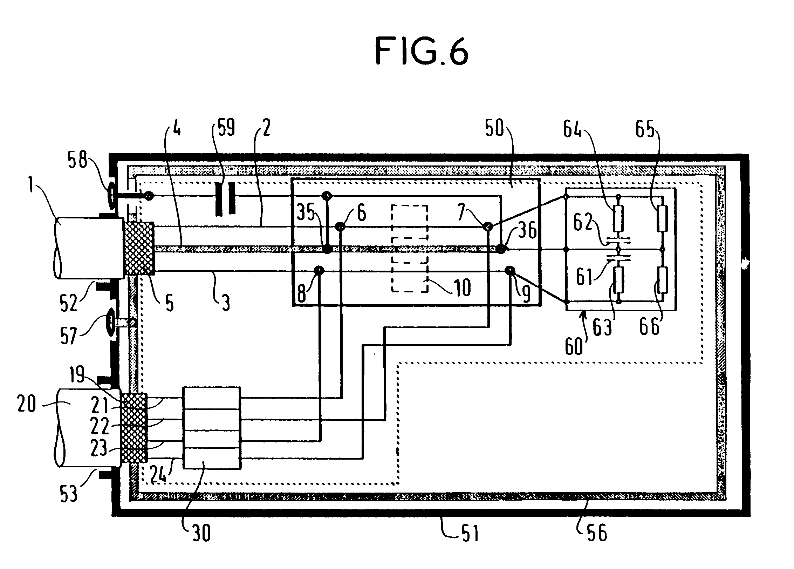

Dans l'exemple de réalisation proposé en figure 6, la cage de Faraday 56 est également agencée pour contenir un circuit de terminaison de ligne 60 destiné à équiper chacune des deux extrémités du câble à drain 1, de manière à éviter la dégradation par effet de désadaptation des signaux transmis entre les appareillages par l'intermédiaire de la liaison de transmission que ce câble 1 constitue.

A cet effet ce circuit de terminaison 60 ferme classiquement cette liaison sur son impédance caractéristique à l'extrémité où il est connecté; classiquement réalisé sous la forme d'un petit bloc moulé connectable comportant un circuit imprimé, il possède ici un point milieu destiné à être connecté au drain 4 du câble 1, deux circuits RC série qui sont composés chacun d'un condensateur 61 ou 62 et d'une résistance 63 ou 64 et qui sont connectés entre le drain et respectivement chacun l'un des fils de transmission 2 et 3, via les pièces de connexion 36, 7 et 9, ainsi que deux résistances 65 et 66 montées chacune en parallèle à l'un des circuits RC évoqués ci-dessus.

Comme le câble 1 se termine dans les connecteurs situés à ses deux extrémités, un seul des orifices 52, 55 prévus pour sa traversée d'un connecteur situé en extrémité est exploité et il est loisible de maintenir l'autre orifice ,ici 55, muré et de disposer le circuit de terminaison 60 dans la zone de la cage de Faraday 56 de ce connecteur qui est prévue pour le passage du câble et qui est située au voisinage de cet orifice 55, muré.

Dans la mesure où il est souhaitable de vérifier le bon fonctionnement de la liaison établie au moyen d'un câble et où les connecteurs sont disposés en un point important de ces liaisons, il est prévu d'équiper le connecteur d'une prise autobouclante reliée aux fils 21 à 24 du câble de dérivation et débouchant hors de la cage de Faraday 56 et à l'extérieur du boîtier 51 pour permettre la connexion par enfoncement d'une fiche complémentaire, externe, amovible de desserte d'appareillage auxiliaire.

## Revendications

1. Connecteur destiné à permettre le raccordement d'un équipement émetteur et/ou récepteur d'un appareillage par l'intermédiaire d'un câble de dérivation blindé (20) composé de deux paires de fils (21, 22, 23, 24) de transmission individuellement isolés, à un câble blindé (1), qui comporte une paire de fils (2, 3) de transmission individuellement isolés et un drain (4) de continuité d'écran électromagnétique à l'intérieur d'une gaine (5) constituant l'écran électromagnétique, ledit connecteur comportant à cet effet, un bloc de raccordement composé d'un élément support (50) dans lequel est logé un dispositif de coupure (10) placé entre quatre pièces de connexion par pincement et à cisaillement d'isolant (6 à 9), permettant chacune une connexion individuelle de deux fils isolés et destinées à recevoir chacune un des quatre fils de transmission du câble de dérivation et un des deux fils de transmission du câble à drain, le dispositif de coupure étant déplaçable dans un logement de l'élément support entre une première position permettant le passage de deux fils en traversée entre chacun deux pièces de connexion, situées de part et d'autre d'un compartiment (28 ou 29) du logement et différentes pour les deux fils en traversée, et une seconde position dans laquelle le dispositif de coupure s'interpose entre les pièces de connexion situées de part et d'autre des compartiments du logement, après avoir éventuellement sectionné les fils préalablement en traversée, caractérisé en ce que logé dans un boîtier (51) en matériau isolant, il comporte une cage de Faraday (56) interne où pénètrent les conducteurs des câbles, dans laquelle sont notamment logés l'élément support et les pièces de connexion et à laquelle sont reliées les gaines desdits câbles de manière à former avec ces gaines de câble un contenant étanche aux parasites électromagnétiques et en ce que ladite cage est reliée à deux bornes de masse (57, 58) accessibles de l'extérieur du boîtier (51), directement pour l'une (57) et via un condensateur (59) pour l'autre (58).

2. Connecteur selon la revendication 1, caractérisé en ce que le condensateur (59 ) reliant une des bornes de masse (58) à la cage de Faraday (56) interne est situé à l'intérieur de cette cage.

3. Connecteur selon la revendication 2, caractérisé en ce que le condensateur (59) est relié à la cage de Faraday (56) interne par l'intermédiaire d'au moins une des pièces conductrices (35,36) servant à l'immobilisation sur l'élément support (50) du drain (4) du câble (1) sur lequel le connecteur vient se monter.

4. Connecteur selon la revendication 1, caractérisé en ce que la cage de Faraday (56) interne qu'il comporte contient un circuit de terminaison de ligne (60) constitué de manière à fermer la ligne de transmission que constitue le câble (1) sur son impédance caractéristique, lorsque ce connecteur est destiné à être monté à une des extrémités dudit câble (1).

5. Connecteur selon la revendication 4 caractérisé en ce que le circuit de terminaison (60) qu'il comporte est logé de l'autre côté de l'élément support (50) par rapport à l'orifice (58) par où pénètre le câble (1) à drain dans le boîtier (51), étant relié aux pièces de connexion (7, 9,36) prévues pour les fils et le drain de ce câble qui sont situées de l'autre côté de l'élément support par rapport au dit orifice par où pénètre le câble (1).

6. Connecteur selon la revendication 1, caractérisé en ce que le boîtier (51) comporte une prise autobouclante reliée aux fils (21 à 24) du câble de dérivation et débouchant hors de la cage de Faraday et à l'extérieur du boîtier pour permettre la connexion par enfoncement d'une fiche complémentaire, externe, amovible de desserte d'appareillage auxiliaire.

## Patentansprüche

1. Verbinder für den Anschluß eines Sende- und/oder Empfangsteils eines Geräts über ein abgeschirmtes Abzweigungskabel (20), bestehend aus zwei Paaren von einzeln isolierten Übertragungsdrähten (21, 22, 23, 24), an ein abgeschirmtes Kabel (1), das ein Paar von einzeln isolierten Übertragungsdrähten (2, 3) und einen die Kontinuität der elektromagnetischen Abschirmung bewirkenden Erdungsdraht im Inneren einer die elektromagnetische Abschirmung bildenden Hülle (5) aufweist, wobei der Verbinder zu diesem Zweck einen Anschlußblock mit einem Trägerelement (50) aufweist, in welchem eine Schneidevorrichtung (10) zwischen vier je einen Leiter einklemmenden und dessen Isolation durchschneidenden Anschlußstücken (6 bis 9) untergebracht ist, wobei jedes Anschlußstück einen individuellen Kontakt zwischen zwei isolierten Drähten ermöglicht und dazu bestimmt ist, einen der vier Übertragungsdrähte des Abzweigungskabels und einen der beiden Übertragungsdrähte des mit Erdungsleiter versehenen Kabels aufzunehmen, wobei die Schneidevorrichtung in einem Raum des Trägerelements zwischen einer ersten Position, die den Durchgang von zwei Drähten jeweils zwischen zwei Anschlußstücken ermöglicht, die zu beiden Seiten eines für die beiden durchlaufenden Drähte unterschiedlichen Abteils (28 oder 29) des Raums angeordnet sind, und einer zweiten Position verschoben werden kann, in der sich die Schneidevorrichtung zwischen die zu beiden Seiten der Abteile des Raums befindlichen Anschlußstücke setzt, nachdem sie ggf. die durchlaufenden Drähte vorher durchgetrennt hat, dadurch gekennzeichnet, daß der in einem Gehäuse (51) aus isolierendem Material untergebrachte Verbinder einen inneren Faraday-Käfig (56) aufweist, in den die Leiter der Kabel eindringen und in welchem insbesondere das Trägerelement und die Anschlußstücke untergebracht sind sowie mit dem die Hüllen der Kabel verbunden sind, derart, daß sie mit den Kabelhüllen ein gegen elektromagnetische Störungen dichtes Behältnis bilden, und daß der Käfig mit zwei Masseklemmen (57, 58) verbunden ist, die von außerhalb des Gehäuses (51) her zugänglich sind, und zwar die eine Klemme (57) direkt und die andere Klemme (58) über einen Kondensator (59).

2. Verbinder nach Anspruch 1, dadurch gekennzeichnet, daß der eine der Massenklemmen (58) mit dem inneren Faraday-Käfig (56) verbindende Kondensator (59) im Inneren dieses Käfigs angeordnet ist.

3. Verbinder nach Anspruch 2, dadurch gekennzeichnet, daß der Kondensator (59) mit dem inneren Faraday-Käfig (56) über mindestens eines der leitenden Anschlußstücke (35, 36) verbunden ist, die zur Fixierung des Erdleiters (4) des Kabels (1), auf dem der Verbinder montiert wird, auf dem Trägerelement (50) dienen.

4. Verbinder nach Anspruch 1, dadurch gekennzeichnet, daß der innere Faraday-Käfig (56), den er umfaßt, eine Leitungsabschlußschaltung (60) enthält, die so aufgebaut ist, daß sie die Übertragungsleitung, die das Kabel (1) bildet, mit ihrem Wellenwiderstand abschließt, wenn der Verbinder dazu bestimmt ist, an einem der Enden des Kabels (1) montiert zu werden.

5. Verbinder nach Anspruch 4, dadurch gekennzeichnet, daß die Abschlußschaltung (60), die er umfaßt, relativ zu der Öffnung (58), durch die das mit Erdleiter versehene Kabel (1) in das Gehäuse (51) eintritt, auf der anderen Seite des Trägerelements (50) untergebracht ist, wobei sie mit den für die Drähte und den Erdungsleiter des Kabels vorgesehenen Anschlußstücke (7, 9, 36) verbunden ist, die sich relativ zu der Öffnung, durch die das Kabel (1) eindringt, auf der anderen Seite des Trägerelements befinden.

6. Verbinder nach Anspruch 1, dadurch gekennzeichnet, daß das Gehäuse (51) einen selbsteinschleifenden Steckanschluß aufweist, der mit den Drähten (21 bis 24) des Abzweigungskabels verbunden ist und aus dem Faraday-Käfig heraus an der Außenseite des Gehäuses mündet, um das Anschließen durch Einstecken eines abnehmbaren, äußeren, komplementären Bedienungssteckers für ein Hilfsgerät zu ermöglichen.

## Claims

1. Connector for connecting a transmitter and/or receiver using a shielded drop and insert cable (20) comprising two pairs of individually insulated transmission wires (21, 22, 23, 24) to a shielded cable (1) which comprises one pair of individually insulated transmission wires (2, 3) and an electromagnetic shield continuity drain conductor (4) within an electromagnetic shield (5), said connector comprising to this end a terminal block comprising a support member (50) in which is accommodated a cutting device (10) disposed between four clamp and insulation cutting type connecting members (6 to 9) each enabling an individual connection of two insulated wires and each designed to receive one of the four transmission wires of the drop and insert cable and one of the two transmission wires of the cable, the cutting device being movable inside a housing of the support member between a first position enabling two wires to be passed between each of the two connecting members, situated to either side of a compartment (28 or 29) of the housing and different for the two crossing wires, and a second position in which the cutting device is disposed between the connecting members situated to either side of the compartments of the housing, optionally after first cutting the crossing wires, characterised in that, accommodated in an insulative material housing (51), it comprises an internal Faraday cage (56) into which the cable conductors extend, in which are accommodated the support member and the connecting members and to which the shields of said cables are connected in such a way as to form with said cable shields a container proof against electromagnetic radiation and in that said cage is connected to two earthing terminals (57, 58) accessible from outside the housing, one (57) directly and the other (58) via a capacitor (59).

2. Connector according to claim 1 characterised in that the capacitor (59) connecting one of the grounding terminals (58) to the internal Faraday cage (56) is inside said cage.

3. Connector according to claim 2 characterised in that the capacitor (59) is connected to the internal Faraday cage (56) by at least one of the conductive members (35, 36) immobilising on the support member (50) the drain conductor (4) of the cable (1) on which the connector is mounted.

4. Connector according to claim 1 characterised in that the internal Faraday cage (56) that it includes contains a line terminator circuit (60) adapted to close the transmission line constituted by the cable (1) across its characteristic impedance when the connector is fitted to one end of said cable (1).

5. Connector according to claim 4 characterised in that the terminator circuit (60) that it includes is housed on the other side of the support member (50) relative to the port (58) whereby the cable (1) enters the housing (51), being connected to the connecting members (7, 9, 36) provided for the wires and the drain conductor of said cable which are situated on the other side of the support member relative to said port through which the cable (1) enters.

6. Connector according to claim 1 characterised in that the housing (51) comprises a break-in jack connected to the wires (21 to 24) of the drop and insert cable and accessible from outside the Faraday cage and outside the housing to enable a connection by plugging in an external complementary removable plug connected to auxiliary equipment.
